# EUROPEAN PATENT SPECIFICATION

(11) **EP 3 720 986 B1**
(45) Date of publication and mention of the grant of the patent: **16.11.2022**
(21) Application number: 18822276.4
(22) Date of filing: 02.12.2018
(51) Int. Cl.: C23C 18/14, G03F 7/004, G03F 7/20

(54) **CONDUCTING A PHOTOCHEMICAL REACTION IN A MOVING MENISCUS**
DURCHFÜHRUNG EINER PHOTOCHEMISCHEN REAKTION IN EINEM SICH BEWEGENDEN MENISKUS
RÉALISATION D'UNE RÉACTION PHOTOCHIMIQUE DANS UN MÉNISQUE MOBILE

(30) Priority: 04.12.2017 PL 42369117
(43) Date of publication of application: 14.10.2020
(73) Proprietor: Uniwersytet Jagiellonski, 31-007 Krakow (PL); Akademia Gorniczo-Hutnicza im. Stanislawa Staszica w Krakowie, 30-059 Krakow (PL)
(72) Inventor: AWSIUK, Kamil, 30-884 Krakow (PL); DABCZYNSKI, Pawel, 26-130 Suchedniow (PL); MICHALIK, Maciej, 31-619 Krakow (PL); RYSZ, Jakub, 32-070 Czernichow (PL); MARZEC, Mateusz, 31-234 Krakow (PL)
(74) Representative: Kancelaria Eupatent.pl Sp. z.o.o
(86) International application number: PCT/EP2018/083248
(87) International publication number: WO 2019/110456

(56) References cited:
- WO-A2-01/38940
- DE-A1-102009 053 943
- KR-B1- 100 969 347
- US-A- 4 370 356
- US-A1- 2012 100 304

## Description

### TECHNICAL FIELD

The present disclosure relates to a method and to an apparatus for conducting a photochemical reaction in a meniscus that moves on the surface of a sample. The apparatus and method are used for producing structures with a controlled planar shape, thickness and width, that can be deposited on various types of substrates (conductive or nonconductive). The structures may have a form of paths and can be made of inorganic (such as gold or silver) or organic materials.

### BACKGROUND

Conventional methods of forming paths, such as conductive paths, involve a complex procedure: designing a path, preparing a mask pattern, transferring it onto a PCB, path etching, PCB cleaning after etching. Thus, it is a time-, material-, and energy-consuming process. Therefore, new, cost-effective methods for forming surface structures are sought.

Printing methods using inkjet printers are increasingly more common. However, they require special inks, dedicated to a particular substrate and use.

Metallic paths can be obtained using materials of high conductivity (such as silver or gold) or organic materials. Such types of structures should be obtained in a controlled way, preferably from easily prepared solutions containing a deposited substance.

Another important type of modified surfaces are functional coatings in a form of self-assembled monolayers (SAM). They have significant importance in nanotechnology and nanofabrication methods. Such types of layers are usually obtained through deposition (e.g. grafting or the use of the characteristics of the relationship between a surface and molecules being applied) of photoreactive organic substances with the use of lithography technologies. It is important to obtain particular arrangement patterns of such a type of layers, as this translates into specific surface properties in subsequent steps. Therefore, the precise control of the arrangement, the size of an SAM layer, or local modifications of monomolecular layers is very important.

There are known methods for depositing gold metallic layers such as the one disclosed in US7641944. It includes preparing a solution containing gold ions and a reductant, immersing an object that is to be plated in the solution, irradiating the object with ultraviolet rays, and depositing gold on the object to form gold plating when the ultraviolet rays cause a photochemical reaction in the solution. The method does not provide for selectivity of the deposition of a metallic film.

A publication *"*Photochemical Deposition of Patterned Gold Thin Films" [Jpn. J. Appl. Phys., Vol. 45, No. 48 (2006)] discloses a method for creating gold paths through the reduction of auric ions to the metallic form. A drop of a solution containing HAuCl₄, Na₂SO₃ and ethylenediamine is applied onto a glass surface or a surface coated with ITO, or a PVC board, or a silicon wafer. In the subsequent step, a mask with a previously prepared pattern is applied and irradiated with ultraviolet rays using a high-pressure mercury lamp. This causes the reduction of auric ions according to the pattern of the mask.

Another publication, *"*Laser Photochemical Deposition of Gold from Trialkylphosphine Alkylgold(I) Complexes" (Chem. Mater. 1994, 6, 1712-1718), discloses deposition of paths of metallic gold from metal-organic precursors. The deposition is performed using laser photolysis (wavelength of 257 nm). However, structures obtained using that method demonstrate contamination with precursors and/or organic ligands, or photolysis by-products.

A publication "Photochemical Patterning of a Self-Assembled Monolayer of 7-Diazomethylcarbonyl-2,4,9-trithiaadmantane on Gold Films via Wolff Rearrangement" (Langmuir 2004, 20, 4933-4938*)* discloses use of selective irradiation of a surface coated with a photoreactive organic compound. The substrate surface is coated with a thin gold film, on which a compound containing sulphur atoms in its structure is adsorpted, creating an SAM. Then, a mask is applied to the prepared monolayer and irradiated using a UV lamp. This led to creating a pattern in the monomolecular film according to the mask. Such an approach requires preparing a mask every time.

US4370356 discloses an apparatus for meniscus coating.

### SUMMARY

There is a need to provide apparatus and method for producing metallic or organic paths that allow creating paths without the use of a mask. Preferably, the paths shall have a predetermined spatial structure during the layer application without additional process steps. Additionally, there is a need to allow fast production of homogeneous paths having a desired thickness and width using small amount of chemical reagents.

There is disclosed herein an apparatus and a method for conducting a photochemical reaction in a meniscus according to the appended claims.

The main advantage of the present invention is the possibility to form a path (metallic or organic) with a structure that is precisely determined at the application stage, with a small number of process steps. As opposed to methods known in the state of the art, the present method does not require any additional steps, such as for example preparing an irradiation mask in lithographic methods, which streamlines the manufacturing process and is cost-effective.

The present invention significantly reduces material costs, because conducting a reaction in a meniscus does not require immersing the entire substrate in a solution, but only a small amount of the solution is applied between a cylinder and the substrate. For example, for a microscope slide having a width of 25 mm, the amount of the solution applied ranges from 50 to 200 µl depending on the cylinder distance from the substrate. By moving the meniscus over the substrate (using the cylinder and a linear guide) as well as by turning on and off the source of light, or changing the position of the light in relation to the bar that spreads the precursor solution, it is possible to initiate a photochemical reaction locally (in precisely determined positions on the base surface) and, thus, to deposit a material on the substrate, for example to produce gold paths.

In one aspect of the invention, it is possible to deposit a metallic layer of silver or to modify the chemical properties of the substrate.

The method according to the invention allows creating functional patterns on the surface of the substrate with different performance characteristics.

Additionally, by controlling luminous intensity of the light and movement velocity, it is possible to modify the thickness of the layer produced.

### BRIEF DESCRIPTION OF DRAWINGS

The method and apparatus for conducting a photochemical reaction in a meniscus are presented herein by means of non-limiting example embodiments shown in a drawing, wherein:
Figure 1 shows schematically an example of an apparatus for conducting a photochemical reaction in a moving meniscus in an axonometric view;
Figure 2 shows schematically structural elements of the apparatus of Figure 1 for controlling the cylinder distance from the sample surface, as well as the parallelism of the cylinder in relation to the sample surface;
Figures 3a, 3b and 3c show a schematic representation of various arrangements of the cylinder in relation to the substrate;
Figures 3d, 3e and 3f show graphs representing the position of the laser dot as a function of the distance of a chuck with the cylinder from the sample surface;
Figures 3g, 3h and 3i show graphs representing the laser dot position difference as a function of the distance of the chuck with the cylinder from the sample surface;
Figure 4 shows a photograph of a glass substrate with a gold path produced using a deuterium lamp;
Figure 5 shows a picture of the gold path of Figure 4 made using an optical microscope (4× magnification);
Figure 6 shows a picture of the boundary of the gold path of Figure 4 made using an optical microscope (10× magnification);
Figure 7 shows an image of AU₃⁻ ions for the path of Figure 4 obtained using ToF-SIMS;
Figure 8 shows a picture of a gold path obtained using a LED with a maximum emission of 250 nm;
Figure 9 shows a transverse profile of an obtained gold path obtained;
Figure 10a and 10b show the result of the conductivity measurement of gold precipitated from the gaseous phase (Au-PVD) and gold deposited using the photochemical method in a meniscus (Au-UV); Figure 11 and Figure 12 show, respectively, a photograph and microscopic images of a silver path produced photochemically in a meniscus.

### DETAILED DESCRIPTION

The following detailed description is of the best currently contemplated modes of carrying out the invention. The description is not to be taken in a limiting sense, but is made merely for the purpose of illustrating the general principles of the invention.

### FIRST EXAMPLE

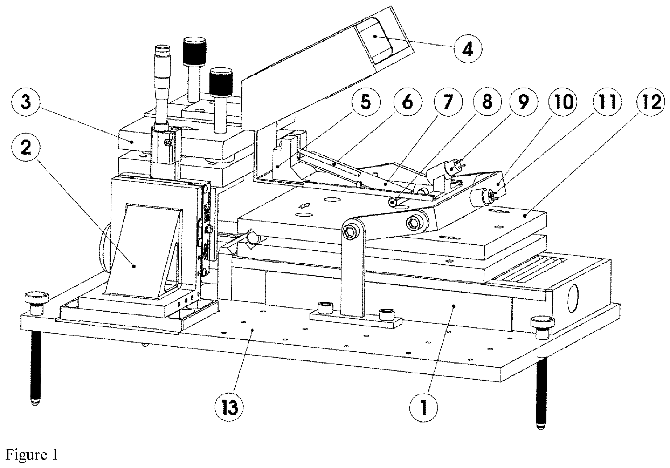

An apparatus for conducting a photochemical reaction in a moving meniscus allowing, among other things, producing paths with a set structure according to one example of this invention is shown schematically in Figure 1.

The main element of the apparatus is a movement system 1, preferably a linear guide, that allows the movement of the substrate in relation to a cylinder 8, which causes the movement of the meniscus. The linear guide 1 allows choosing an appropriate velocity, as well as acceleration. Another element of said apparatus is a chuck 5 which allows mounting the cylinder 8 that spreads the precursor solution. The apparatus further comprises a holder 10 for mounting a light source 11 used for initiating a photochemical reaction. In order to obtain a homogeneous layer over as large an area as possible, it is important to ensure the appropriate arrangement of the cylinder 8 that spreads the precursor solution in relation to the sample surface, and to level the entire system. In order to achieve that, a set of elements allowing the appropriate arrangement of particular components of the apparatus is used. A micrometer 2 allows positioning the cylinder 8 to an appropriate distance from the sample with an accuracy of several µm. A first platform 12 allows correcting the sample slope, so that the cylinder 8 moves at a constant height along its entire length. A second platform 3 allows correcting the cylinder 8 tilt, so that it is parallel to the sample surface. The entire apparatus is placed on a third platform 13 with three screws mounted that allow levelling of the entire apparatus to produce paths with a set structure.

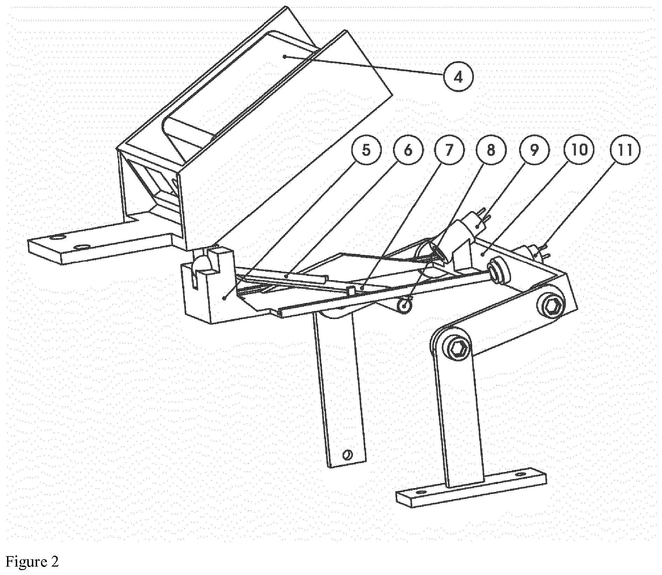

In order to control the distance of the cylinder 8 from the sample surface, as well as to correct its tilt, the system for controlling the approach of an AFM probe to a sample surface, known, for example, from atomic force microscopy (AFM), is used. In a standard system known in the state of the art, the laser dot is reflected from the surface of a bar on which the AFM probe is mounted and it is tracked by a four-segment photodetector. When the AFM probe comes in contact with the surface, the bar bends, which changes the position of the laser dot on the photodetector. In the distance adjustment system for controlling the cylinder 8 distance as used in this invention (as shown schematically in Figure 2), an extended beam of light generated by the laser 9 (not a spot beam, as known in the AFM systems) is used, with the cylinder 8 that spreads the precursor solution not connected with the flexible bar, but with a rigid element, e.g. slide 7. The entire distance adjustment system for controlling the distance comprises the chuck 5, the cylinder 8, the ball end rod 6, the slide 7, the laser 9, the holder with camera 4 - with the entire system mounted to the platform 3. The slide 7 with the cylinder 8 fixed to it is mounted in the chuck 5 using a ball end rod 6. Such installation allows not only the movement of the cylinder 8 and the slide 7 in the vertical direction (in relation to the apparatus), but also their turning, which is important when positioning the cylinder 8 in parallel to the sample surface so that its distance from the sample surface is the same along its entire length.

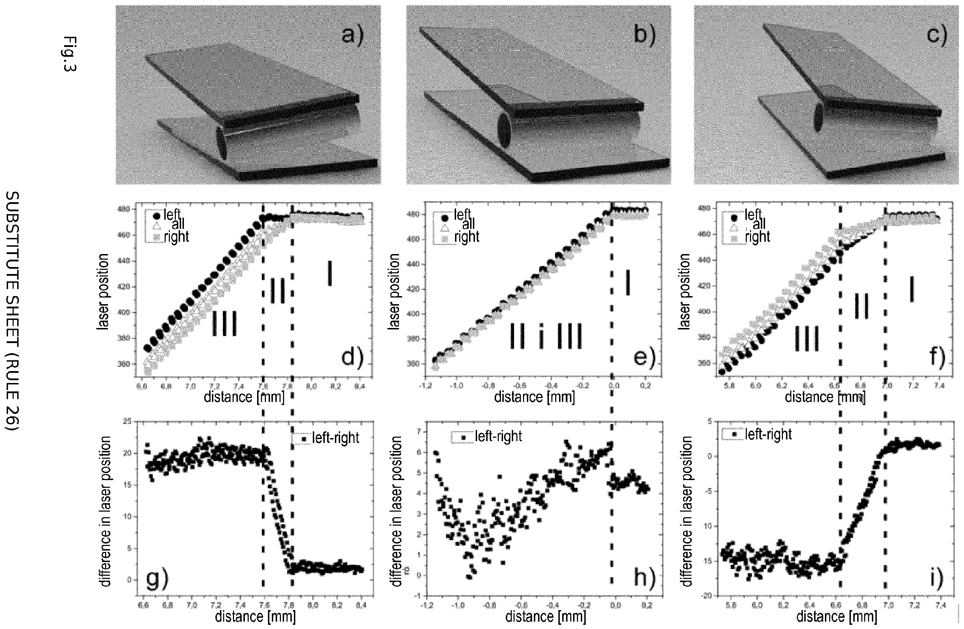

The operation of the distance adjustment system for controlling the cylinder 8 distance from the substrate involve detecting the extended beam coming from the laser 9 and reflected from the surface of the slide 7 on which the cylinder 8 is mounted. The laser beam is tracked by the detector 4 in the form of a camera mounted in a holder. If the cylinder 8 is parallel to the sample surface, then when it comes in contact with the surface, it touches the sample along its entire length and, as a result, with the chuck 5 further approaching the sample surface, the cylinder 8 moves upwards (without turning), which is observable in the detector 4 as a shift of the entire laser beam. If the cylinder 8 is not arranged in parallel to the surface, then when it is approaching the surface, one of its ends (right or left) comes in contact with the sample, which leads to the turning of the cylinder 8 and the slide 7. Consequently, the laser beam turns. When the chuck 5 with the cylinder 8 is further approaching the sample, at some point the other end of the cylinder 8 touches the sample surface (the cylinder 8 becomes aligned with the sample), which makes the entire element go upwards, as is the case with the parallel arrangement of the cylinder 8 in relation to the sample surface. An appropriate algorithm implemented in the controller of the distance adjustment system records the position of the entire reflected laser beam 9, as well as the position of the beam reflected from the right and the left end of the slide 7 with the cylinder 8 mounted. By tracking the changes in those three signals, it is possible to detect an incorrect position of the cylinder 8 in relation to the sample surface, as well as to set the appropriate cylinder 8 distance to the sample surface. Sample graphs are presented in Figures 3a-3h, which presents examples where the left end (3a, 3d, 3g) or the right end (3c, 3f, 3i) of the cylinder 8 is positioned higher, as well as where the cylinder 8 is parallel (3b, 3e, 3h) to the sample surface.

By analysing the changes in the laser beam position in the camera 4 as a function of the distance, three main steps may be distinguished:
I) the cylinder 8 is above the sample surface,
II) one of the ends of the cylinder 8 touches the sample,
III) the other end of the cylinder 8 touches the sample and the entire cylinder 8 lies in parallel to the sample surface.

In step I, no changes in the laser beam position are observed in the camera 4 as the sample surface is being approached. When one of the ends of the cylinder 8 starts to touch the sample (step II), the cylinder 8 and the slide 7 starts to turn in the chuck 5 (Figure 3a, 3c). Consequently, a laser beam position change is observed in the camera 4 (Figure 3d, 3f). What is more, because of the turning of the cylinder 8, different positions of the laser beam reflected from the left end and the right end of the slide 7 with the cylinder 8 mounted are observed (Figure 3g, 3i). When the other end of the cylinder 8 touches the sample (step III), another change in the laser beam position can be observed in camera 4 (Figure 3d, 3f) and, at that moment, the entire cylinder 8 rests on the sample surface. If the chuck 5 with the cylinder 8 is further lowered, it starts to go upwards and the difference between the positions of the laser beam reflected from the left and from the right end of the slide 7 with the cylinder 8 mounted is constant (Figure 3g, 3i). If the cylinder 8 is turned in relation to the sample surface, two "breakdowns" in the signal representing the laser beam position can be observed in the camera 4 as recorded as a function of the distance, as well as a clear spike in the difference between the positions of the laser beam reflected from the left and from the right end of the slide 7 with the cylinder 8 mounted can be seen. When the cylinder 8 is parallel to the substrate, both of its ends touch the sample surface at the same time (the cylinder 8 touches the sample along its entire length) without causing it to turn. It is observed as a single "bend" in the signal representing the laser beam position in the camera 4 recorded as a function of the distance (Figure 3e), while there is no clear spike in the difference between the positions of the laser beam reflected from the left and from the right end of the slide 7 with the cylinder 8 (Figure 3h). The presented distance adjustment system allows setting its distance from the sample surface with the accuracy of several micrometres; the distance adjustment system is also sufficiently sensitive to set the angle between the sample surface and the cylinder 8 (no parallelism of both surfaces) with the accuracy of 0.1°.

In the apparatus for a photochemical reaction in a meniscus, the cylinder 8 that spreads the precursor solution is made of glass. However, this does not constitute a limitation and a skilled person will be able to use other types of materials for the cylinder 8 without deviating from the object of this invention. If UV light is used for the photochemical reaction and it is directed at the 90° angle against the substrate, it is necessary to replace the glass cylinder with a quartz cylinder. Additionally, an element allowing precise positioning of the light source in relation to the meniscus is necessary.

Into the above described apparatus for conducting a photochemical reaction in a meniscus a substrate is inserted, which is placed on a platform 12 equipped with a platform inclination adjustment system for adjusting an inclination in at least one plane, preferably in three planes, and embedded in a linear guide 1. Because the platform 13 stands on three levelling feet, it is possible to level the entire apparatus. Similarly, the platform 3 is equipped with a substrate inclination adjustment system for adjusting an inclination in at least two planes (preferably in three planes) and the chuck 5 for the slide 7 with the rod 6 and the cylinder 8 is fastened to it rigidly. After levelling, a precursor solution is applied between the substrate and the cylinder 8 to create a meniscus suspended between the cylinder 8 and the substrate, and, subsequently, by ensuring linear movement using the linear guide 1, the meniscus is moved. The thickness and homogeneity of the created layer is changed by ensuring an appropriate distance and turning the cylinder 8 in relation to the substrate and by controlling the velocity and acceleration of the substrate linear movement, as well as the luminous intensity of the light directed at the meniscus.

### SECOND EXAMPLE - obtaining a gold metallic path using a deuterium lamp

A precursor solution was prepared by mixing the following components in the following order:
1. 100 µL of aqueous solution of 1.5 M NaCl
2. 10 µL of aqueous solution of 250 mM HAuCl₄
3. 90 µL of aqueous solution of 200 mM Na₂SO₃ (freshly prepared)

As a base, a standard microscope glass slide coated with 3-mercaptopropyltrimethoxysilane (MPTES) was used. The apparatus for conducting a photochemical reaction in a meniscus was set up as follows:
- the glass cylinder placed 1.5 mm above the substrate;
- the velocity of the meniscus movement over the substrate 0.02 mm/s;
- the amount of the solution creating the meniscus between the cylinder and the substrate 200 µl.
- the light falling onto the sample surface at an angle from 15° to 45° led out in an optical fibre cable from the deuterium lamp through the holder 10 and 11.

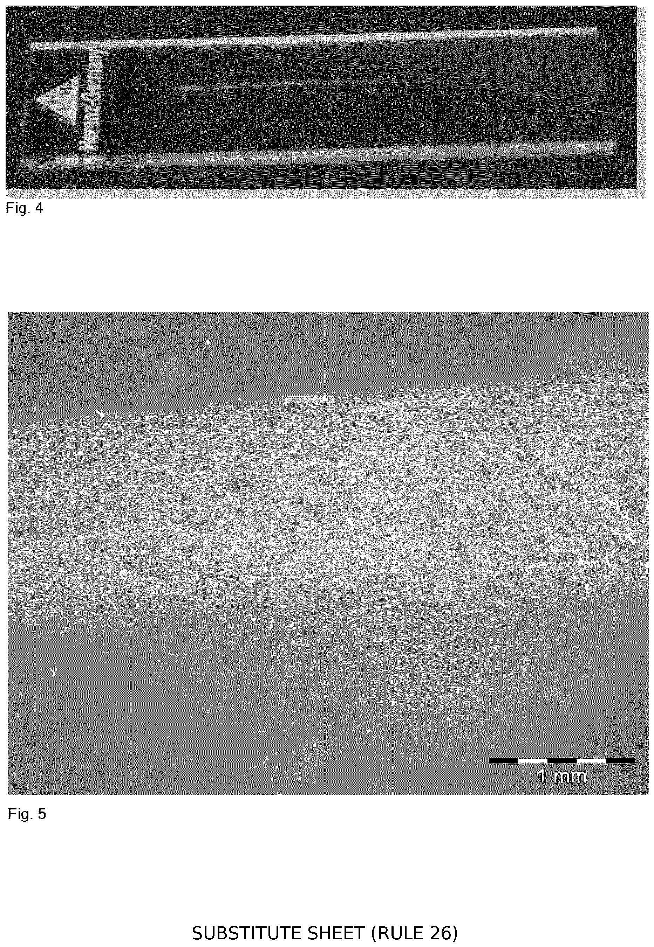

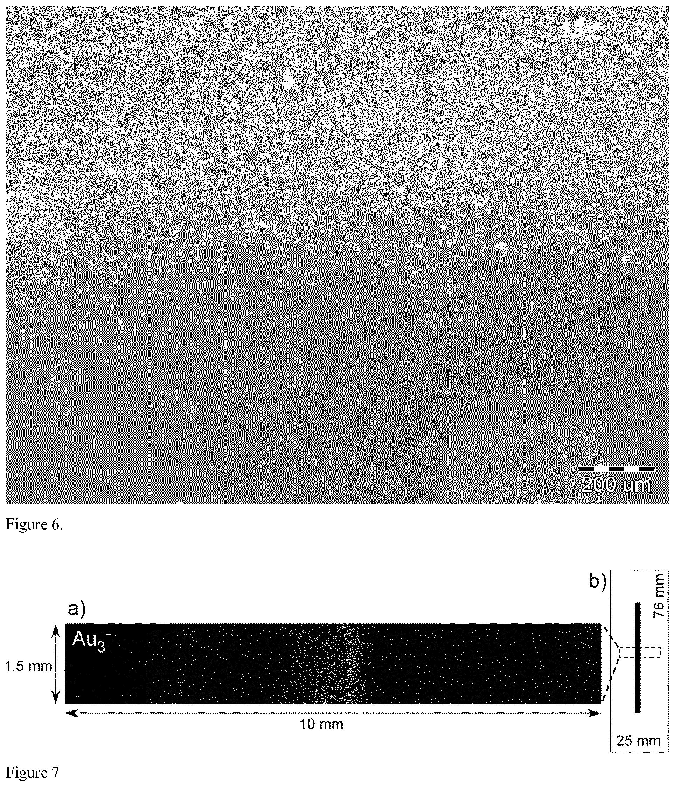

The slide coated with MPTMS was placed on the platform 12 and the precursor solution was dropped in between the substrate surface and the cylinder 8. The solution was spread between the substrate and the cylinder 8, creating a meniscus. Then, a photochemical reaction was initiated by irradiating a spot within the meniscus using the light from the optical fibre cable inserted through the holder 11. Continuing the irradiation, the meniscus was moved over the substrate. Under the influence of the light, gold was precipitated from the solution (Figure 4) and was deposited on the substrate, which allowed creating a gold path with the length of 4 cm and the width of 1.5 mm (Figures 5 and 7) - comparable to the width of the light dot falling onto the meniscus. A Time-of-Flight secondary ion mass spectrometer (ToF-SIMS) showed that the path visible in Figure 4 and 5 is made of gold (Figure 7). Optical microscope images show the internal structure of the path consisting of gold nanoparticle agglomerates precipitated from the solution under the influence of light (Figure 6).

### THIRD EXAMPLE - obtaining a gold metallic path using a LED with a maximum emission of 250 nm

The precursor solution was prepared by mixing the following components in the following order:
1. 100 µL of aqueous solution of 1.5 M NaCl
2. 10 µL of aqueous solution of 250 mM HAuCl4
3. 90 µL of aqueous solution of 200 mM Na₂SO3 (freshly prepared)

As a base, a standard 15×75-mm microscope glass slide was used. The base was cleaned in an ultrasonic cleaner for 10 minutes, first in toluene and then in 2-propanol. Subsequently, the base was incubated for 30-60 minutes in (3-mercaptopropyl) trimethoxysilane (MPTES), 1% v/v solution in toluene, and then the base was washed twice in toluene.

The apparatus for conducting a photochemical reaction in a meniscus was set up as follows:
- the glass cylinder placed 1.5 mm above the substrate;
- the velocity of the meniscus movement over the substrate 0.02 mm/s;
- the amount of the solution creating the meniscus between the cylinder and the substrate 200 µl;
- the light led out in an optical fibre cable from the LED with a maximum emission of 250 nm through the holder 10 and 11, and falling onto the sample surface at an angle from 15° to 45°.

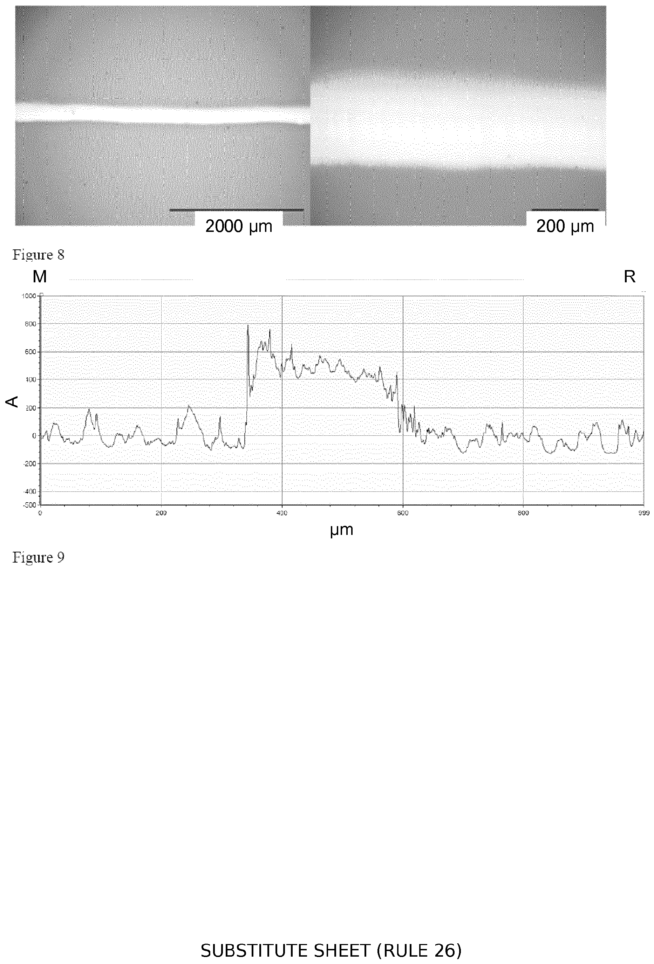

The slide coated with MPTMS was placed on the platform 12 and the precursor solution was dropped in between the substrate surface and a guiding element 8 in the form of a cylinder. The solution was spread between the substrate and the cylinder 8, creating a meniscus. Then, a photochemical reaction was initiated by irradiating a spot within the meniscus using the light from the optical fibre cable inserted through the holder 11. Continuing the irradiation, the meniscus was moved over the substrate at the velocity of 0.02 mm/s. Under the influence of the light, gold was precipitated from the solution and deposited onto the substrate, creating a gold path (Figure 8) with the length of 4 cm and the width of ca. 0.25 mm - Figure 9 shows the transverse profile of the gold path obtained, the approximate dimensions of the cross-section are: width ca. 250 µm and height 50 nm, with the area of the cross-section amounting to 12 µm².

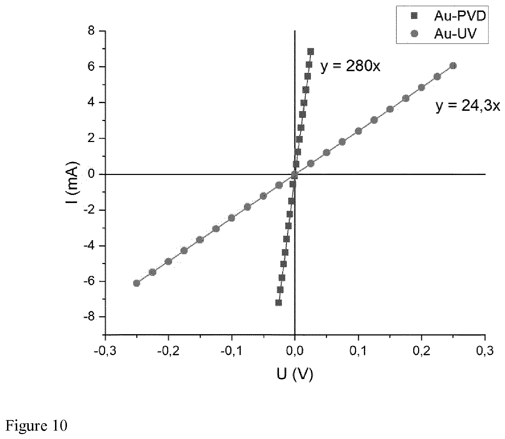

On the obtained paths, 60 nm thick gold contacts were vapour-deposited and the path conductivity was measured in a double-contact mode. The measurement result is presented in Figure 10. The resistance of the vapour-deposited gold film (Au-PVD) determined based on the slope of the curve representing the current-voltage relationship is 3.6 ohm. The resistance of the photochemically obtained path (Au-UV) is 41.1 ohm, which - after taking into account the path cross-section - means that its specific resistance is 1.7E-07 ohm^{∗}m, that is ca. 1 order of magnitude more than gold in volume (2.20E-08 ohm^{∗}m).

FOURTH EXAMPLE - obtaining a silver metallic path.

As a liquid solution on the substrate, the precursor solution was prepared from the following components:
- 10 µL of aqueous solution of 500 mM AgNo₃;
- 10 µL of aqueous solution of 500 mM trisodium citrate;
- 1500 µL of water
(the final concentration of AgNO₃ and trisodium citrate was 3 mM)

As a base, a standard microscope glass slide was used, as in the third example.

The apparatus for conducting a photochemical reaction in a meniscus was set up as follows:
- the glass cylinder placed 1.5 mm above the substrate;
- the velocity of the meniscus movement over the substrate 0.01 mm/s;
- the amount of the solution creating the meniscus between the cylinder and the substrate 200 µl;
- the light led out in an optical fibre cable from the 475 nm laser through the holder 10 and 11, and falling onto the sample surface at an angle from 15° to 45°.

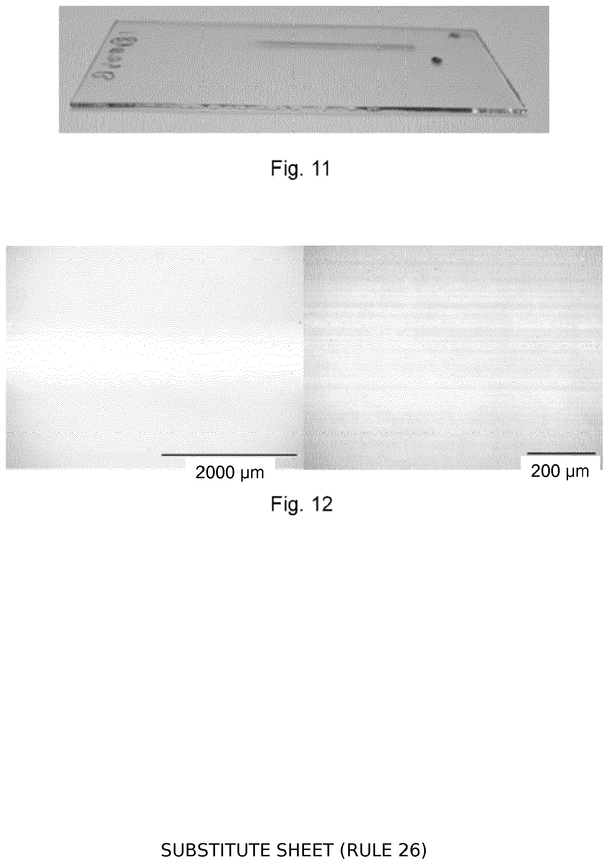

The slide coated with MPTMS was placed on the platform 12 and the precursor solution was dropped in between the substrate surface and a guiding element 8 in the form of a cylinder. The solution was spread between the substrate and the cylinder 8, creating a meniscus. Then, a photochemical reaction was initiated by irradiating a spot within the meniscus using the light from the optical fibre cable inserted through the holder 11. Continuing the irradiation, the meniscus was moved over the substrate at the velocity of 0.01 mm/s. Under the influence of the light, silver was precipitated from the solution and deposited onto the substrate, creating a silver path with the length of ca. 4 cm and the width of ca. 1 mm (Figure 11) - comparable to the width of the light dot falling onto the meniscus. Figure 12 shows a microscopic image of the silver path. A Time-of-Flight secondary ion mass spectrometer (ToF-SIMS) showed that the path visible in Figure 11 is made of silver.

### FURTHER EXAMPLES

While the invention has been described with respect to a limited number of examples, it will be appreciated that many variations, modifications and other applications of the invention may be made. Therefore, the claimed invention as recited in the claims that follow is not limited to the examples described herein.

## Claims

1. An apparatus for conducting a photochemical reaction in a meniscus, the apparatus comprising:
- a cylinder (8) configured to spread a precursor solution in the meniscus over a substrate;
- a movement system (1) configured to effect movement of the cylinder (8) in relation to the substrate;
- a platform (12) configured to hold the substrate;
- a distance adjustment system configured to adjust the distance (2) of the cylinder from the substrate;
- a substrate inclination adjustment system configured to control a tilt of the cylinder (2) in relation to the substrate; **characterised in that** the apparatus further comprises a holder (10) with a light source (11) configured to illuminate the meniscus.

2. The apparatus according to claim 1, wherein the movement system (1) is a linear guide.

3. The apparatus according to claim 2, wherein the platform (12) is mounted on the linear guide (1) to effect linear movement of the substrate with respect to the fixed cylinder (8).

4. The apparatus according to any of previous claims, wherein the distance adjustment system is a micrometer screw.

5. The apparatus according to any of previous claims, wherein the holder (10) is configured to adjust the position of the light source (11) with relation to the substrate.

6. The apparatus according to any of previous claims, wherein the distance adjustment system comprises a laser (9), a detector (4) and a cylinder (8) mounted to a slide (7), wherein the laser (9) is configured to emit a beam of light directed to the slide (7) connected with the cylinder (8), such that the beam reflected from the slide (7) falls onto the detector (4).

7. The apparatus according to any of previous claims, further comprising a platform inclination adjustment system configured to control a tilt of the platform (12) in at least one plane, and preferably in three planes.

8. The apparatus according to any of previous claims, wherein the cylinder (8) is mounted to the cylinder platform (3) adjustable in at least two planes, preferably three planes.

9. The apparatus according to any of previous claims, comprising an apparatus platform (13) standing on levelling feet, preferably three levelling feet.

10. The apparatus according to any of previous claims, wherein the cylinder (8) is made of a material selected from a group comprising: an insulating material, preferably glass, a quartz glass, metal.

11. A method for conducting a photochemical reaction in a moving meniscus, the method comprising the following steps:
a) preparing a precursor solution that contains a precursor;
b) providing a substrate;
c) creating a meniscus by dosing the precursor solution between the substrate and a cylinder (8);
d) moving the precursor solution by moving the cylinder (8) with respect to the substrate or the substrate with respect to the cylinder (8) and illuminating the precursor solution using a light source (11) mounted on a holder to initiate and continue a chemical reaction;
e) during the movement, controlling at least one of: acceleration of movement, velocity of movement, distance of the cylinder (8) with respect to the substrate, inclination of the cylinder (8) with respect to the substrate, and intensity of the light that illuminates the substrate.

12. The method according to claim 11, comprising illuminating the substrate with a light beam having specific dimensions, preferably a width of 1.5 mm.

13. The method according to any of claims 11-12 wherein a metallic path is formed on the substrate, wherein the substrate is preferably a glass surface or a glass surface coated with a film of an organosilicon compound.

14. The method according to any of claims 11-13 wherein the glass cylinder is placed at a distance of 1.50 mm from the substrate, while the cylinder movement velocity is 0.02 mm/s.

15. The method according to any of claims 11-12 wherein the light from the source (11) is inclined at an angle from 15° to 90° with respect to the substrate.

## Patentansprüche

1. Vorrichtung zum Durchführen einer photochemischen Reaktion in einem Meniskus, wobei die Vorrichtung Folgendes umfasst:
- einen Zylinder (8), der konfiguriert ist, um eine Vorläuferlösung in dem Meniskus über einem Substrat zu verteilen;
- ein Bewegungssystem (1), das konfiguriert ist, um Bewegung des Zylinders (8) in Bezug auf das Substrat zu bewirken;
- eine Plattform (12), die konfiguriert ist, um das Substrat zu halten;
- ein Abstandseinstellsystem, das konfiguriert ist, um den Abstand (2) des Zylinders von dem Substrat einzustellen;
- ein Substratneigungseinstellsystem, das konfiguriert ist, um eine Schrägstellung des Zylinders (2) in Bezug auf das Substrat zu steuern;
**dadurch gekennzeichnet, dass** die Vorrichtung ferner Folgendes umfasst
einen Halter (10) mit einer Lichtquelle (11), die konfiguriert ist, um den Meniskus zu beleuchten.

2. Vorrichtung nach Anspruch 1, wobei das Bewegungssystem (1) eine lineare Führung ist.

3. Vorrichtung nach Anspruch 2, wobei die Plattform (12) an der linearen Führung (1) montiert ist, um lineare Bewegung des Substrats in Bezug auf den festen Zylinder (8) zu bewirken.

4. Vorrichtung nach einem der vorhergehenden Ansprüche, wobei das Abstandseinstellsystem eine Mikrometerschraube ist.

5. Vorrichtung nach einem der vorhergehenden Ansprüche, wobei der Halter (10) konfiguriert ist, um die Position der Lichtquelle (11) in Bezug auf das Substrat einzustellen.

6. Vorrichtung nach einem der vorhergehenden Ansprüche, wobei das Abstandseinstellsystem einen Laser (9), einen Detektor (4) und einen Zylinder (8) umfasst, der an einem Schlitten (7) montiert ist, wobei der Laser (9) konfiguriert ist, um einen Lichtstrahl zu emittieren, der auf den Schlitten (7) gerichtet ist, der mit dem Zylinder (8) verbunden ist, sodass der Strahl, der von dem Schlitten (7) reflektiert wird, auf den Detektor (4) fällt.

7. Vorrichtung nach einem der vorhergehenden Ansprüche, ferner umfassend ein Plattformneigungseinstellsystem, das konfiguriert ist, um eine Schrägstellung der Plattform (12) in zumindest einer Ebene und bevorzugt in drei Ebenen zu steuern.

8. Vorrichtung nach einem der vorhergehenden Ansprüche, wobei der Zylinder (8) an der Zylinderplattform (3) in zumindest zwei Ebenen, bevorzugt drei Ebenen, einstellbar montiert ist.

9. Vorrichtung nach einem der vorhergehenden Ansprüche, umfassend eine Vorrichtungsplattform (13), die auf Nivellierfüßen, bevorzugt drei Nivellierfüßen, steht.

10. Vorrichtung nach einem der vorhergehenden Ansprüche, wobei der Zylinder (8) aus einem Material hergestellt ist, das aus einer Gruppe ausgewählt ist, die Folgendes umfasst: ein isolierendes Material, bevorzugt Glas, ein Quarzglas, Metall.

11. Verfahren zum Durchführen einer photochemischen Reaktion in einem sich bewegenden Meniskus, wobei das Verfahren die folgenden Schritte umfasst:
a) Herstellen einer Vorläuferlösung, die einen Vorläufer enthält;
b) Bereitstellen eines Substrats;
c) Erzeugen eines Meniskus durch Dosieren der Vorläuferlösung zwischen dem Substrat und einem Zylinder (8);
d) Bewegen der Vorläuferlösung durch Bewegen des Zylinders (8) in Bezug auf das Substrat oder des Substrats in Bezug auf den Zylinder (8) und Beleuchten der Vorläuferlösung unter Verwendung einer Lichtquelle (11), die auf einem Halter montiert ist, um eine chemische Reaktion zu initiieren und fortzusetzen;
e) während der Bewegung, Steuern von zumindest einem von: Bewegungsbeschleunigung, Bewegungsgeschwindigkeit, Abstand des Zylinders (8) in Bezug auf das Substrat, Neigung des Zylinders (8) in Bezug auf das Substrat und Intensität des Lichtes, welches das Substrat beleuchtet.

12. Verfahren nach Anspruch 11, umfassend das Beleuchten des Substrats mit einem Lichtstrahl, der spezifische Abmessungen aufweist, bevorzugt eine Breite von 1,5 mm.

13. Verfahren nach einem der Ansprüche 11-12, wobei ein metallischer Pfad auf dem Substrat gebildet ist, wobei das Substrat bevorzugt eine Glasoberfläche oder eine Glasoberfläche ist, die mit einem Film aus einer Organosiliziumverbindung beschichtet ist.

14. Verfahren nach einem der Ansprüche 11-13, wobei der Glaszylinder in einem Abstand von 1,50 mm von dem Substrat platziert ist, während die Zylinderbewegungsgeschwindigkeit 0,02 mm/s ist.

15. Verfahren nach einem der Ansprüche 11-12, wobei das Licht von der Quelle (11) in einem Winkel von 15 ° bis 90 ° in Bezug auf das Substrat geneigt ist.

## Revendications

1. Appareil permettant de réaliser une réaction photochimique dans un ménisque, l'appareil comprenant :
- un cylindre (8) conçu pour étaler une solution de précurseur dans le ménisque sur un substrat ;
- un système de déplacement (1) conçu pour effectuer le déplacement du cylindre (8) par rapport au substrat ;
- une plateforme (12) conçue pour maintenir le substrat ;
- un système de réglage de distance conçu pour régler la distance (2) du cylindre au substrat ;
- un système de réglage d'inclinaison de substrat conçu pour commander l'inclinaison du cylindre (2) par rapport au substrat ; **caractérisé en ce que** l'appareil comprend en outre un support (10) doté d'une source de lumière (11) conçue pour éclairer le ménisque.

2. Appareil selon la revendication 1, ledit système de déplacement (1) étant un guide linéaire.

3. Appareil selon la revendication 2, ladite plateforme (12) étant montée sur le guide linéaire (1) pour effectuer un déplacement linéaire du substrat par rapport au cylindre fixe (8).

4. Appareil selon l'une quelconque des revendications précédentes, ledit système de réglage de distance étant une vis micrométrique.

5. Appareil selon l'une quelconque des revendications précédentes, ledit support (10) étant conçu pour régler la position de la source de lumière (11) par rapport au substrat.

6. Appareil selon l'une quelconque des revendications précédentes, ledit système de réglage de distance comprenant un laser (9), un détecteur (4) et un cylindre (8) monté sur un coulisseau (7), ledit laser (9) étant conçu pour émettre un faisceau de lumière dirigé vers le coulisseau (7) relié au cylindre (8), de sorte que le faisceau réfléchi par le coulisseau (7) frappe le détecteur (4).

7. Appareil selon l'une quelconque des revendications précédentes, comprenant en outre un système de réglage d'inclinaison de plateforme conçu pour commander l'inclinaison de la plateforme (12) dans au moins un plan, et de préférence dans trois plans.

8. Appareil selon l'une quelconque des revendications précédentes, ledit cylindre (8) étant monté sur la plateforme de cylindre (3) réglable dans au moins deux plans, de préférence trois plans.

9. Appareil selon l'une quelconque des revendications précédentes, comprenant une plateforme d'appareil (13) reposant sur des pieds de mise à niveau, de préférence trois pieds de mise à niveau.

10. Appareil selon l'une quelconque des revendications précédentes, ledit cylindre (8) étant constitué d'un matériau choisi dans le groupe comprenant : un matériau isolant, de préférence du verre, un verre de quartz, du métal.

11. Procédé permettant de réaliser une réaction photochimique dans un ménisque en mouvement, le procédé comprenant les étapes suivantes :
a) la préparation d'une solution de précurseur qui contient un précurseur ;
b) la fourniture d'un substrat ;
c) la création d'un ménisque en dosant la solution de précurseur entre le substrat et un cylindre (8) ;
d) le déplacement de la solution de précurseur en déplaçant le cylindre (8) par rapport au substrat ou le substrat par rapport au cylindre (8) et l'éclairage de la solution de précurseur à l'aide d'une source de lumière (11) montée sur un support pour initier et poursuivre une réaction chimique ;
e) pendant le déplacement, la commande d'au moins un paramètre parmi : l'accélération du déplacement, la vitesse de déplacement, la distance du cylindre (8) par rapport au substrat, l'inclinaison du cylindre (8) par rapport au substrat, et l'intensité de la lumière qui éclaire le substrat.

12. Procédé selon la revendication 11, comprenant l'éclairage du substrat avec un faisceau lumineux présentant des dimensions spécifiques, de préférence une largeur de 1,5 mm.

13. Procédé selon l'une quelconque des revendications 11 à 12, un chemin métallique étant formé sur le substrat, ledit substrat étant de préférence une surface de verre ou une surface de verre revêtue d'un film d'un composé organosilicié.

14. Procédé selon l'une quelconque des revendications 11 à 13, ledit cylindre de verre étant placé à une distance de 1,50 mm du substrat, tandis que la vitesse de déplacement du cylindre est de 0,02 mm/s.

15. Procédé selon l'une quelconque des revendications 11 à 12, ladite lumière provenant de la source (11) étant inclinée d'un angle de 15° à 90° par rapport au substrat.
